# EUROPEAN PATENT APPLICATION

(11) **EP 4 711 777 A1**
(43) Date of publication of application: **18.03.2026**
(21) Application number: 25202521.8
(22) Date of filing: 16.09.2025
(51) Int. Cl.: G01R 29/08, G08B 21/02, F16P 3/14

(54) **ELECTRICAL SAFETY DEVICE AND METHOD FOR OPERATING SAID DEVICE**

(30) Priority: 16.09.2024 IT 202400020539
(71) Applicant: Seval Elettrica S.r.l., 23010 Piantedo (SO) (IT)
(72) Inventor: ABATE, Valerio, 22014 Dongo (CO) (IT); ARDENGHI, Roberto, 23823 Colico (LC) (IT)
(74) Representative: Caldon, Giuliano

(57) **Abstract**

Electrical safety device (1), which comprises a support element (2) arranged for being applied to an operator, an electric field sensor (3), mounted on the support element (2) and arranged for measuring an electric field generated by a power line and at least one position sensor (4), mounted on the support element (2) and arranged for detecting movements of the operator. The device (1) also comprises a processing unit (5), which is operatively connected to the electric field sensor (3) in order to detect field measurements (E) containing intensity values of the electric field, is operatively connected to the position sensor (4) in order to detect position measurements (S) associated with corresponding field measurements (E), and is adapted to calculate, at least from the field measurements (E) and from the position measurements (S), variations (V) of the electric field associated with the movements. In addition, the processing unit (5) is arranged for generating a warning signal (A) as a function of the variations (V).

## Description

### Field of application

The present invention regards an electrical safety device and a method for operating said device, according to the preamble of the respective independent claims.

The safety device according to the invention can be employed in the maintenance works on power lines both in industrial and in residential fields.

In particular, the present device is intended to be applied to an operator (for example mounted on the harness of the latter) in order to detect the presence of a dangerous electric field generated by the power line at which the operator is working, such to ensure the necessary safety conditions during maintenance works.

The safety device according to the invention is advantageously employable for a power line at any voltage level.

Therefore, the present device is inserted in the field of production of safety devices for electrical plants and for electrical systems for power transmission and distribution.

### State of the art

The alternating current power lines are subjected to more or less frequent periodic maintenance work, during which they are usually previously sectioned upstream of the section to be maintained, so as to place such section at zero potential.

In this manner, an operator can approach the line without risking an electrical discharge and therefore can safely execute the maintenance operations.

Otherwise, the operator would risk electrical discharge not only due to contact with a wire of the power line, but also in proximity to the latter, due to the electric field generated by the voltage, at which the wire is placed, which can lead to electrical discharges on the operator as a function of the intensity of the electric field itself and of the air conditions (e.g. humidity, temperature, etc.).

In order to prevent such risk, for example in the event in which the line section that must be subjected to maintenance has not been correctly sectioned, electrical safety devices are known in the reference field, which are intended to be worn by the operator, e.g. mounted on the harness of the latter, in order to detect the presence of the electric field in proximity to the line to be maintained.

Such devices of known type are configured for measuring a size representative of the electric field, e.g. its intensity measured in kV/m, and for signaling during the approach of the operator to the electrical wires, for example by means of an acoustic signal, when such size exceeds a predetermined threshold value, beyond which the operator himself/herself is advised to approach no further.

Also known from the document EP 3144686 A1 is a safety device which measures, in addition to the electric field intensity, also the position of the operator.

In this manner, the devices of the prior art allow the operations in safe conditions on the line that must be subjected to maintenance by the operator, who can therefore approach the line with risking an electrical discharge.

Nevertheless, the safety devices of the prior art described above have in practice proven that they do not lack drawbacks.

The main drawback lies in the fact that such devices are provided with poor application flexibility.

Indeed, each electrical safety device of known type is employable for the operations in a specific line at a specific voltage level, e.g. 132 kV, 220 kV, 380 kV, etc.

In particular, as set forth above, the aforesaid devices detect when a threshold value of the electric field has been exceeded, and such threshold value is predetermined based on the application for which the device itself is intended, i.e. based on the electric field expected at a certain distance for the voltage level of the specific power line for which the device is designed.

Therefore, each device is only usable for the power line for which it was specifically designed.

Such drawback complicates the maintenance operations on multiple lines with different voltage levels by a company for managing the distribution and/or transmission power lines, since it requires that each operator be provided the same number of safety devices as voltage levels that the company is charged to maintain.

A further drawback of the safety devices of the prior art lies in the fact that the latter have a preferred arrangement in which they must be placed in order to correctly detect the electric field.

Indeed, such devices of the prior art generally employ a plate capacitor such as a sensor for detecting and measuring the electric field, which however requires that the aforesaid plates be placed orthogonal to the electric field lines generated by the wire of the line.

Therefore, the aforesaid devices must be employed by the operator in a preferred direction of approach to the wires of the line to be maintained, making the line approach operations arduous. In addition, if the operator does not take on the necessary position, the safety device might not correctly detect the electric field and hence might not reliably signal the danger conditions.

### Presentation of the invention

In this situation, the problem underlying the present invention is that of overcoming the abovementioned drawbacks of the solutions of known type, by providing an electrical safety device and a method for operating said device which can be employed for various types of power lines (in particular characterized by different voltage levels).

Further object of the present invention is to provide an electrical safety device and a method for operating said device which are capable of detecting an electric field regardless of the position taken on by the operator or regardless of the power line approach directions. Further object of the present invention is to provide an electrical safety device and a method for operating said device which are capable of reliably detecting the electric field.

Further object of the present invention is to provide a detection device which is compact and is simple to use.

Further object of the present invention is to provide a detection device which is simple and inexpensive to attain.

### Brief description of the drawings

The technical characteristics of the invention, according to the aforesaid objects, are clearly seen in the contents of the below-reported claims and the advantages thereof will be more evident in the following detailed description, made with reference to the enclosed drawings, which represent a merely exemplifying and non-limiting embodiment of the invention, in which:
- figure 1 shows a perspective view of the electrical safety device, object of the present invention;
- figure 2 shows a further perspective view of the safety device of figure 1 with several parts removed in order to better illustrate other parts;
- figure 3 shows a sectional view of a spherical capacitor of the present present safety devices;
- figure 4 shows a schematized top view of an electronic circuit board of the present safety devices;
- figure 5 shows a block diagram representative of the method for operating the present device;
- figure 6 shows an example of electric field distribution lines for a very high voltage line at 380 kV close to one pole.

### Detailed description of a preferred embodiment

With reference to the enclosed drawings, reference number 1 refers to an electrical safety device according to the invention.

Such device is advantageously employable an operator during maintenance works on power lines, specifically alternating current power lines.

In particular, in the following present description, with the expression power lines it must be intended aerial power lines, in particular transmission and/or distribution lines, as well as grounded power lines, and additionally industrial and/or residential power plants.

The present electrical safety device 1 comprises a support element 2 arranged for being applied to an operator.

Preferably, the device 1 is advantageously worn by the operator, in particular it is applied on the harness worn by the latter, for example at a shoulder, or on a protective helmet of the operator himself/herself.

Advantageously, the support element 2 is at least partially made of electrically insulating material, such as for example a plastic material.

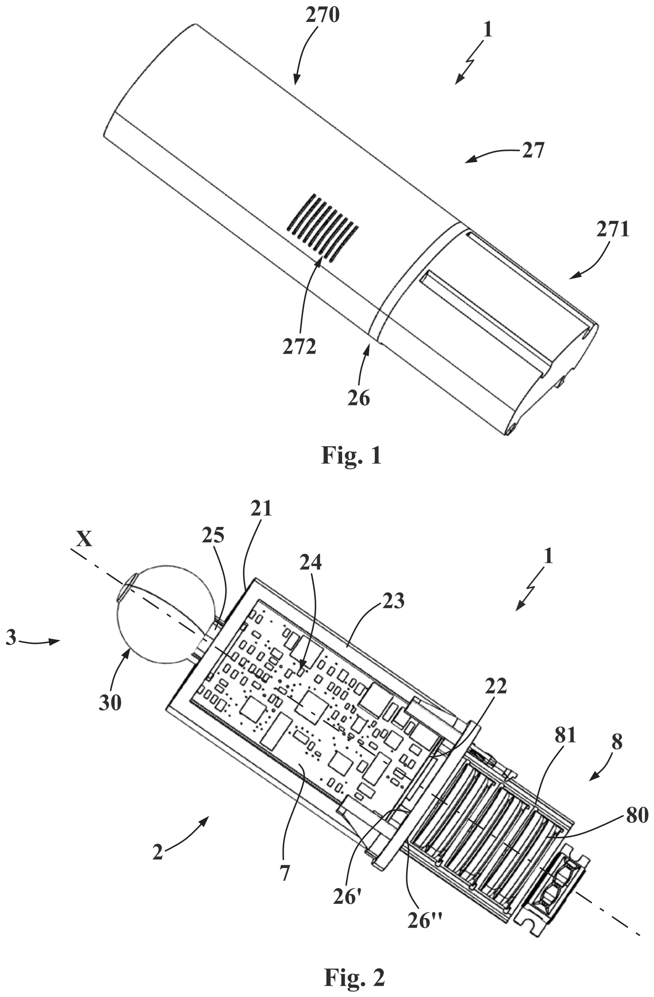

In particular, as illustrated in the example of figure 2, the support element 2 comprises a support frame 23 which is preferably extended along a main extension direction X between a first end 21 and an opposite second end 22.

The device 1 also comprises an electric field sensor 3, which is mounted on the support element 2 and is arranged for measuring at least one electric field generated by at least one power line.

Advantageously, the electric field sensor 3 is mounted at the first end 21 of the support frame 23.

In particular, the electric field sensor 3 projects protruding from the first end of the support element 2 along the main extension direction X.

The device 1 also comprises a position sensor 4, which is mounted on the support element 2 and is arranged for detecting movements of the operator.

Advantageously, the support element 2 comprises an electronic circuit board 7, which carries the position sensor 4 mounted thereon and is preferably mounted on the support frame 23. In particular, the support frame 23 is made of frame form, which at its interior delimits a central opening 24 with the electronic circuit board 7 placed at its interior.

More in detail, the electronic circuit board 7 is provided with an external edge mechanically connected to the frame of the support frame 23.

The device 1 also comprises a processing unit 5, which is operatively connected to the electric field sensor 3 in order to detect field measurements E containing at least intensity values of the electric field.

Advantageously, the processing unit 5 is mounted on the electronic circuit board 7 and comprises preferably a microprocessor.

The processing unit 5 is also operatively connected to the position sensor 4 in order to detect position measurements S associated with corresponding field measurements E.

The processing unit 5 is also adapted to calculate, at least from the field measurements E and from the position measurements S, variations V associated with the movements.

In particular, the aforesaid variations V are calculated as a variation of the field measurements E with respect to the (simultaneous) variations of the position measurements S.

For example, the processing unit 5 is configured for acquiring a field measurement E and a corresponding position measurement S, respectively carried out by the electric field sensor 3 and by the position sensor 4 preferably at a same instant and then acquiring a new field measurement E and position measurement S at a successive instant, hence calculating the variations V based on such measurements.

The processing unit 5 is also arranged for generating a warning signal A as a function of the variations V.

In particular, such warning signal A is indicative of a danger condition for the operator, for example indicating a limit electric field, or a limit distance from a line wire (calculated in particular based on the measured electric field), beyond which the operator would no longer be situated in safety conditions.

In this manner, the warning signal A generated by the processing unit 5 of the electrical safety device 1 is generated not only as a function of the field measurements E, but also from the position measurements S and, more precisely, from a correlation of the latter. Therefore, the device 1 is capable of signaling a limit condition to the operator, beyond which the operator himself/herself is in danger condition, accounting for the movement of the operator within an electric field, and more precisely within the electric field generated by the line that must be subjected to maintenance.

In particular, the progression of the electric field as a function of the movement carried out by the operator allows identifying danger conditions regardless of the specific power line where the operator is working, since it allows obtaining characteristics of the electric field that allow recognizing the type of power line that generated it and identifying the corresponding danger conditions.

Advantageously, the electric field sensor 3 is an omnidirectional electric field sensor.

In this manner, the operator can approach the line under maintenance, taking on any position and any direction, with the omnidirectional electric field sensor 3 which is capable of correctly measuring the electric field without being oriented in a particular direction, e.g., perpendicular, with respect to the electric field lines.

Advantageously, the electric field sensor 3 comprises a spherical capacitor 30.

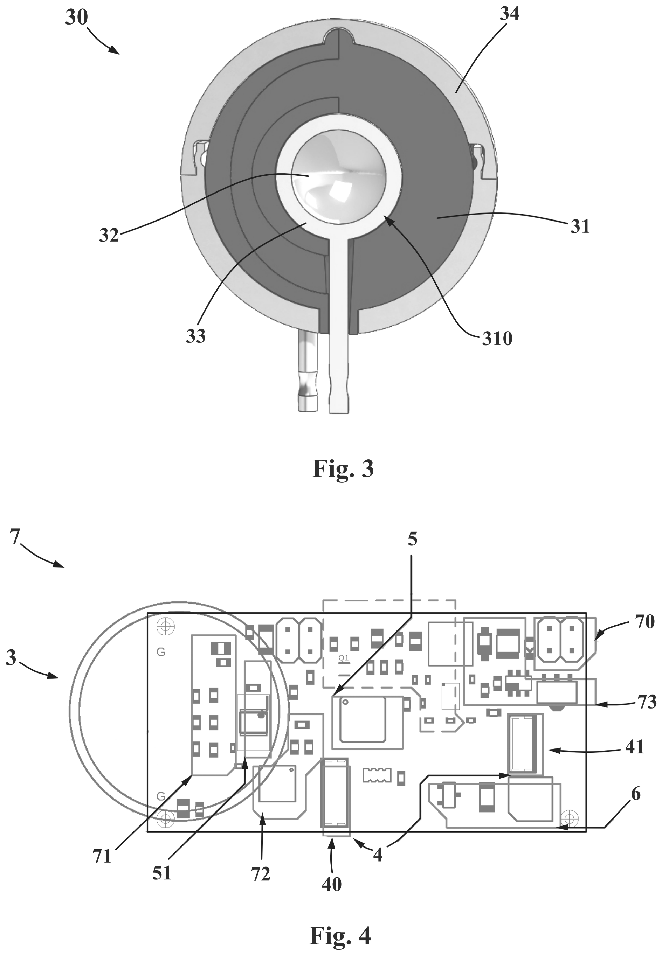

In particular, with reference for example to figure 3, the spherical capacitor 30 comprises an external reinforcement 31, of hollow spherical shape, defining an internal volume 310, made of conductive material.

More in detail, such external reinforcement 31 has a diameter comprised between 10 and 30 mm, preferably 20 mm.

Advantageously, the spherical capacitor 30 comprises an internal reinforcement 32, with spherical shape, which is contained in the internal volume 310 defined by the external reinforcement 31.

Preferably, the internal reinforcement 32 is concentric with the external reinforcement 31, and in particular is spaced from the latter.

More in detail, such internal reinforcement 32 has a diameter smaller than the aforesaid external reinforcement 31, preferably comprised between 3 and 20 mm, e.g. 8 mm.

Advantageously, the spherical capacitor 30 comprises a spacer layer 33, which is interposed between the external reinforcement 31 and the internal reinforcement 32 and is preferably made of electrically insulating material, and still more preferably made of dielectric material, in particular of plastic material, for example obtained by means of 3D printing.

Preferably, the spherical capacitor comprises an external shell 34, which is placed to cover the external reinforcement 31.

In particular, such external shell 34 has hollow spherical shape, containing at its interior the external reinforcement 31, and is preferably made of electrically insulating material, e.g. of plastic material.

More in detail, the external shell 34 is fixed to the support frame 23, in particular at the first end 21 of the latter.

Preferably, the support element 2 of the device 1 comprises a coupling bracket 25, mechanically connected to the support frame 23 at the first end 21 of the latter.

More in detail, the external shell 34 of the spherical capacitor 30 is mechanically connected to the coupling bracket 25, in order to mount the electric field sensor 3 on the support element 2.

Advantageously, the position sensor 4 comprises at least one altimeter 40, which is preferably mounted on the electronic circuit board 7.

In particular, the altimeter 40 (e.g., of manometric type) is configured for detecting a vertical movement of the operator.

More in detail, the processing unit 5 is configured for detecting, from the altimeter 40, height measurements representative of the height variation of the operator, in particular approaching the power line.

In other words, the aforesaid position measurements S advantageously comprise at least one height variation of the operator.

In this manner, the variations V calculated by the processing unit 5 are representative at least of the variation of the electric field generated by the power line with respect to the height variation of the operator.

Advantageously, the position sensor 4 comprises at least one accelerometer 41, which is preferably mounted on the electronic circuit board 7 and is in particular configured for detecting an acceleration of the operator.

More in detail, the processing unit 5 is configured for detecting, by the accelerometer 41, acceleration measurements representative of the variation of the speed of the operator, in particular during the approach of the latter towards power line.

In this manner, the variations V calculated by the processing unit 5 are representative at least of the variation of the electric field generated by the power line with respect to the speed difference with which the operator is approaching the power line.

In other words, if an operator is moving too quickly (in terms of acceleration) within the electric field generated by the power line under maintenance, the processing unit 5 can generate a warning signal A adapted to warn the operator.

Advantageously, the electrical safety device 1 comprises an emitter 6, operatively connected to the processing unit 5 in order to receive the warning signal A, and such warning signal A is adapted to actuate the emitter 6 to emit an alarm signal AL.

Preferably, the emitter 6 is mounted on the support element 2, in particular on the electronic circuit board 7.

In particular, the emitter 6 is of acoustic type, adapted to emit a sound alarm signal AL, and/or of optical type, adapted to emit a light alarm signal AL, and/or of vibration type, adapted to emit a vibrational alarm signal AL.

Advantageously, the emitter 6 is a combination of the types of emitters listed above, being adapted to emit, for example, an alarm signal AL in sound and acoustic form, or sound and vibrational form, etc.

Advantageously, the alarm signal AL emitted by the emitter 6 is susceptible of being perceived by the operator, who therefore is notified by the electrical safety device 1 to be situated in proximity to a danger condition, for example due to the intensity of the electric field to which he/she is subjected (which could generate an electrical discharge) with respect to the power line to which the operator himself/herself is approaching, determined based on the variations V, as described in detail hereinbelow.

In accordance with an embodiment not illustrated in the enclosed figures, the emitter is mechanically separated from the support element 2 of the device 1, and is arranged for being applied in a different point of the body of the operator or integrated in another device of the latter (as a communication device). Advantageously, the device is provided with a communication unit connected to the processing unit 5 in order to receive the warning signals A and in communication (wireless or wired) with the emitter 6 in order to send such warning signals A to the latter. Suitably, the communication unit can be arranged for sending the warning signal also to remote devices, e.g. provided to other operators or at a control station. Advantageously, with reference to figure 2, the device 1 comprises at least one power supply source 8, in particular provided with one or more batteries 80, e.g. placed in series, for power supplying at least the processing unit 5 and, preferably, the position sensor 4 and, more preferably, the electronic circuit board 7 and the components mounted thereon.

More in detail, the support element 2 comprises a base plate 26, which is placed at the second end 22 of the support frame 23, substantially orthogonal with respect to the main extension direction X of the latter.

In particular, the base plate 26 is provided with a first face 26' fixed to the second end of the support frame 23, and with an opposite second face 26", to which the power supply source 8 is fixed.

Advantageously, the power supply source 8 comprises a battery carrier cartridge 81, which is mechanically connected to the second face 26" of the base plate 26 and projects protrudingly from the latter along the main extension direction X.

In particular, the battery carrier cartridge 81 is provided with one or more housing seats in which the batteries 80 are inserted.

Advantageously, the device 1 comprises a power supply input 70, placed on the electronic circuit board 7 and arranged for being connected to the power supply source 8, and in particular to the batteries 80, by means of electrical cables.

Preferably, the device 1 comprises a DC/DC converter 73, which is placed on the electronic circuit board 7 and is connected in input to the power supply source 8 by means of the power supply input 70, and in output to other components placed on the electronic circuit board 7, such as for example the processing unit 5, the position sensor 4 and the emitter 6, in order to convert the wave form of the input voltage into a voltage wave form adapted for the correct operation of the latter.

Advantageously, the support element 2 of the device 1 comprises a cover casing 27, internally hollow, which is placed to contain the electric field sensor 3, the position sensor 4, the processing unit 5, and, advantageously, the power supply source 8 and the support frame 23 and the electronic circuit board 7 placed on the latter.

In particular, the cover casing 27 comprises a first shell 270, placed to cover the electronic circuit board 7 and the electric field sensor 3, and a second shell 271, placed to cover the power supply source 8.

Advantageously, the first shell 270 is mechanically connected, for example removably, to the first face 26' of the base plate 26, and the second shell 271 is mechanically connected, for example removably, to the second face 27" of the base plate 26.

Preferably, the first shell 270 of the cover element 27 is provided with at least one slit 272, placed at the emitter 6, and arranged for facilitating the outflow of the alarm signal AL emitted by the latter, for example in the form of a sound signal.

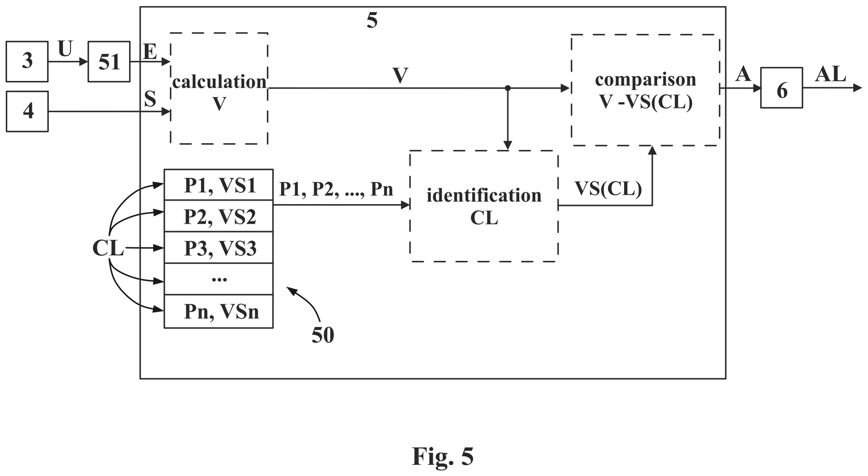

Advantageously, with reference to the example of figure 5, the device 1 comprises a data memory 50, which is advantageously mounted on the electronic circuit board 7 and, for example, can be integrated in the processing unit 5.

In particular, the data memory 50 contains multiple identification classes CL, each of which associated with a corresponding power line, for example a high voltage aerial line (in particular 132 kV or 150 kV) or very high voltage aerial line (in particular 220 kV or 380 kV).

More in detail, each identification class CL contains reference parameters P representative of a spatial distribution of a reference electric field generated by the corresponding power line.

For example, such reference parameters P are determined by the line voltage at which the power line of the corresponding identification class CL, the height of the pole of the power line, the distribution of the phase wires of the power line, etc.

Preferably, the reference parameters P comprise at least the field lines (in particular their distribution and the relative intensity) of the electric field generated by the power line.

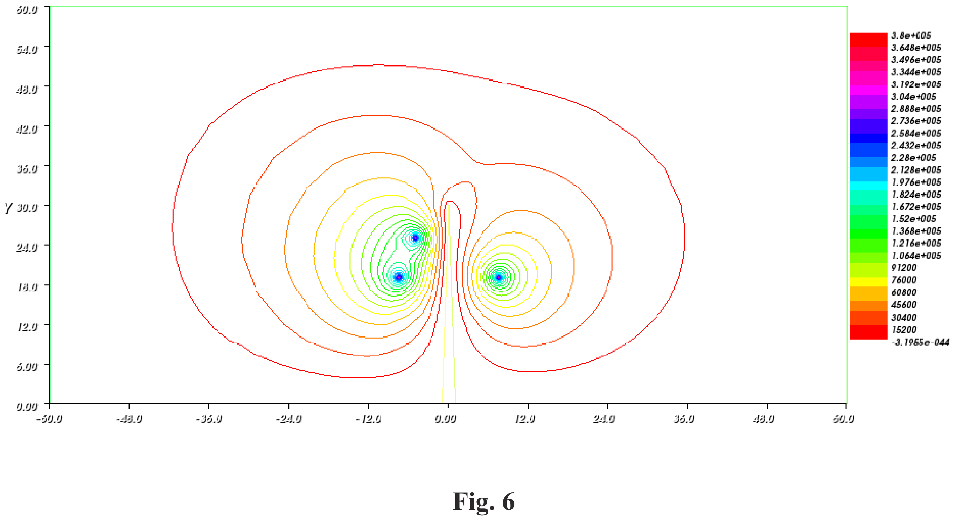

One example of the electric field distribution lines is represented in figure 6, which relates to a very high voltage line at 380 kV in proximity to a support pole or framework.

Advantageously, each identification class CL contains at least one threshold value VS of electric field intensity representative of a danger condition.

In particular, the threshold value VS of a specific identification class CL can differ from the threshold value of a different identification class CL.

For example, with reference to a very high voltage aerial power line at 380 kV, the high voltage at which the wires of the latter are placed causes an ionization of the surrounding air (known in the technical jargon as corona effect), rendering it more conductive. Therefore, the threshold value VS of an identification class CL related to such power line, will be different from the threshold value VS of an information class CL related to a power line at a different voltage where the corona effect is not present.

Advantageously, the processing unit 5 is arranged for comparing the variations V with the reference parameters P of the identification classes CL.

In particular, the reference parameters P of each identification class CL contain information (given in particular by the field lines) related to the electric field at a specific distance from the wire, i.e. at a specific height.

Therefore, in particular, the reference parameters P contain electric field intensity values in the space around the power line, which thus report the variations of the electric field in such space and which, therefore, can be compared with the variations V calculated by the present device 1.

Advantageously, the processing unit 5 is arranged for selecting an identification class CL in which the variations V fall within the reference parameters P.

In other words, the processing unit 5 is configured for detecting a correspondence between the variations V, calculated starting from the measurements detected by the electric field sensor 3 and by the position sensor 4, and the reference parameters P of the identification classes CL.

For example, if the variations V fall within (advantageously with the tolerance intervals) the variations of the electric field given by the reference parameters P of a specific identification class CL, the processing unit 5 selects such identification class CL and hence uses the threshold values VS of the latter in order to detect the danger conditions, as discussed in detail hereinbelow.

Advantageously, the processing unit 5 is arranged for comparing the field measurements E with the threshold value VS of the selected identification class CL.

In particular, the processing unit 5 is arranged for generating the warning signal A as a function of the aforesaid comparison between the field measurements E acquired by the electric field sensor 3 with the threshold value VS.

More in detail, the processing unit 5 is configured for generating the aforesaid warning signal A if the field measurements E are higher than the threshold value VS.

Preferably, as mentioned above, such warning signal A is received by the emitter 6, which is adapted to emit the alarm signal AL in order to inform the operator of the danger conditions.

In this manner, the warning signal A, and advantageously the alarm signal AL, do not depend on the electric field intensity in the absolute sense, but on the electric field intensity referred to the identification class CL and hence to the power line subjected to maintenance.

Advantageously, the electrical safety device 1 is therefore employable for multiple power lines, in particular at different voltage levels, since it is capable of selecting the identification class CL related to a specific power line and selecting a threshold value VS based on the specific power line.

Advantageously, the processing unit 5 is programmed for implementing a continuous measurement state, in which it continuously acquires field measurements E and position measurements S, by means of the electric field sensor 3 and the position sensor 4, respectively. In particular, in each acquisition instant, the processing unit 5 acquires a field measurement E and a corresponding position measurement S.

In such measurement state, the processing unit 5 compares each field measurement E with a minimum field threshold.

If the field measurement E is greater than the minimum field threshold, the processing unit 5 implements a first verification state (in line), in which, based on the field measurements E, it verifies if the electric field increases. More in detail, if the intensities associated with the field measurements E exceed a specific field value, the processing unit 5 implements a first classification state, in which it selects the identification class CL based on the field measurements E and on the position measurements S. For example, the reference parameters P of each identification class CL comprise a corresponding first intensity value and a corresponding first height value (employed in such first verification state). In particular, if the field measurements E exceed the first intensity value and the position measurements S exceed the first height value of the parameters of a specific identification class CL, the processing unit 5 selects such identification class CL.

If the field measurement E is not greater than the minimum field threshold, the processing unit 5 compares the corresponding position measurement S with a minimum height value. If the position measurement S is smaller than such minimum height value, the processing unit 5 executes a new acquisition (of a new field measurement E and of a corresponding new position measurement S). If the position measurement S is greater than such minimum height value, the processing unit 5 implements a second verification state (on a pole), in which, based on the position measurements S, it verifies if the height of the operator increases. More in detail, if the position measurements S exceed a specific height value, the processing unit 5 implements a second classification state, in which it selects the identification class CL based on the field measurements E and on the position measurements S. For example, the reference parameters P of each identification class CL comprise a corresponding second intensity value and a corresponding second height value (employed in such second verification state). If the field measurements E exceed the second intensity value and the position measurements S exceed the second height value of the parameters of a specific identification class CL, the processing unit 5 selects such identification class CL.

In substance, the first verification state is implemented for verifying if the operator approaches the power line along the line spaced from the poles and the second verification state is implemented for verifying if the operator approaches the power line in proximity to the pole (where the electric field conditions are generally different from those far from the pole, for example with intensity field values that are substantially lower, as is visible in the example of figure 6).

Advantageously, the electric field sensor 3 is arranged for generating electrical output signals U as a function of the detected electric field and, preferably, transmitting them to the electronic circuit board 7.

In particular, with reference to figure 4, the device 1 comprises an acquisition circuit 71, which for example is composed of passive electrical components, such as resistors and/or capacitors, is mounted on the electronic circuit board 7 and is arranged for acquiring and conditioning the electrical output signals U generated by the electric field sensor 3, in order to allow the subsequent processing thereof.

Advantageously, the electrical safety device 1 comprises a variable gain amplifier 51, which is electrically connected to the electric field sensor 3 in order to receive the aforesaid output signals U and generate corresponding amplified measurement signals.

In particular, the variable gain amplifier 51 is mounted on the electronic circuit board 7 and is preferably connected to the electric field sensor 3 by means of the acquisition circuit 71, so as to receive the output signals U previously conditioned by the latter.

Advantageously, the processing unit 5 is operatively connected to the electric field sensor 3 through the variable gain amplifier 51 in order to calculate, based on the amplified measurement signals, the field measurements E.

Advantageously, the processing unit 5 is arranged for setting different gains in the variable gain amplifier 51.

In this manner, the device 1 is capable of detecting electric fields in an interval of several orders of magnitude, for example it is capable of detecting electric fields that are dozens of Volt/meter as well as tens of thousands of Volt/meter, setting a different gain in the variable gain amplifier 51.

In particular, such characteristic allows the device 1 to be employable both for the maintenance on high and very high voltage lines, and on low voltage lines, e.g. at 230 V, as is described in detail hereinbelow.

Advantageously, the processing unit 5 is provided with at least one search program in which it sets a minimum gain as gain of the variable gain amplifier 51, for example equal to 1. Advantageously, in the aforesaid search program, the processing unit 5 acquires the aforesaid amplified measurement signals and processes them in order to calculate the field measurements E.

If the processing unit 5 detects that the values of such field measurements E are not significant, it implements the loop operation described hereinbelow, aimed to select a gain adapted to the measured electric field, in order to allow reliable and precise values of the field measurements E.

In particular, in the aforesaid search program, the processing unit 5 iteratively executes, for a maximum number of cycles, so that the field measurements E do not contain significant values, the following operations:
- it increases the gain of a specific increment,
- it acquires new amplified measurement signals, and
- it processes the new amplified measurement signals in order to calculate the field measurements E.

Therefore, if the new measurement signals allow calculating significant values of the field measurements E, the processing unit 5 in the search program selects the current gain and terminates the loop operation. If instead the new measurement signals do not allow calculating significant values of the field measurements E, the processing unit 5 in the search program executes a new cycle of the loop operation, increasing the current gain, reacquiring new amplified measurement signals in order to recalculate the field measurements with the new gain.

This allows selecting a suitable gain without the risk of providing out-of-scale values of the field measurements E, allowing the obtainment of the advantages better described in the method for operating the present device 1.

In particular, by significant values, it must be intended electric field intensity values that are different from a zero value, after having eliminated background noise, in a manner per se known for a man/woman skilled in the art.

Advantageously, the maximum number of cycles is comprised between 32 and 1024, e.g. 64.

In particular, the gain increases with each iteration (so that the field measurements E do not contain significant values) up to reaching a maximum gain at the last cycle, i.e. at the last iteration executed by the search program.

Preferably, the maximum gain is comprised between 100 and 20000, e.g. 1000 or 10000.

Advantageously, the processing unit 5 comprises an analog digital converter (ADC) 71, which is mounted on the electronic circuit board 7 and is arranged for receiving the amplified measurement signals E in analog format and converting them into digital format at the output, in a manner per se known for a man/woman skilled in the art, in order to then transmit them to the processing unit 5.

Also forming the object of the present invention a method for operating an electrical safety device 1 of the above-described type, regarding which hereinbelow, for the sake of description simplicity, the same nomenclature and the same reference numbers will be maintained.

The present operating method comprises a measurement step, in which the electric field sensor 3 measures the electric field generated by at least one power line, a step of detecting movements, in which the position sensor 4 detects movements of the operator and an acquisition step.

In the aforesaid acquisition step, the processing unit 5 detects, by the electric field sensor 3, the field measurements E containing at least intensity values of the electric field, and by the position sensor 4 the position measurements S associated with the corresponding field measurements E.

The present method also comprises a processing step, in which the processing unit 5 calculates, at least from the field measurements E and from the position measurements S, the variations V of the electric field associated with the aforesaid movements, and a signaling step, in which the processing unit 5 generates a warning signal A as a function of the variations V.

In this manner, the device 1 signals a limit condition to the operator, beyond which the operator himself/herself is in danger condition, accounting for the movement of the operator within the electric field generated by the line that must be subjected to maintenance.

Advantageously, the present method comprises a mounting step, preferably preceding the aforesaid measurement step, in which the operator wears the device 1, positioning it for example on his/her harness or on the protective helmet.

Advantageously, the present operating method comprises a first comparison step, in which the processing unit 5 compares the variations V with the reference parameters P of the identification classes CL, and a selection step, in which the processing unit 5 selects one aforesaid identification class CL in which the variations V fall within the reference parameters P.

In particular, the operating method comprises a second comparison step, in which the processing unit 5 compares the field measurements E with the threshold value VS of the selected identification class CL.

Advantageously, in the signaling step, the processing unit 5 generates the warning signal A when the field measurements E exceed the threshold value VS of the selected identification class CL.

In this manner, the device 1 is employable on multiple power lines, which differ from each other by voltage level, arrangement of the wires, height of the latter from the ground, etc., allowing an economic savings for a company that manages multiple power lines to be subjected to maintenance.

Advantageously, the operating method comprises a setting step, in which the variable gain amplifier 51 receives the output signals U generated by the electric field sensor 3 and generates corresponding amplified measurement signals.

Advantageously, in the setting step, the processing unit 5 sets a minimum gain in the variable gain amplifier 51, acquires the amplified measurement signals and processes the amplified measurement signals in order to calculate the field measurements E.

In particular, as long as the field measurements E do not contain significant values, the processing unit 5 executes iteratively, for the maximum number of cycles, the following operations: it increases the minimum gain of the aforesaid specific increment, it acquires new amplified measurement signals and it processes the new amplified measurement signals in order to calculate the field measurements E.

In this manner, the device 1 is capable of detecting the presence of electric fields whose intensity is comprised in an interval of several orders of magnitude, e.g. from a few dozen Volt/meter to tens of thousands of Volt/meter, adapting the gain of the variable gain amplifier 51 in order to precisely acquire the field measurements E.

Therefore, the present operating method allows the device 1 to be employed in both high voltage and low voltage applications.

For example, when the operator approaches a power line at low voltage, in particular in a home system and, therefore, not at elevation, the processing unit 5 sets a high gain (for example 100, 1000 or 10000) in the variable gain amplifier 51, so as to detect a relatively low electric field.

In particular, when the operator approaches the wire of such power line, the processing unit 5 acquires the field measurements E calculated with a high gain and, simultaneously, acquires the position measurements S, which however do not detect any height movement of the operator himself/herself.

The processing unit then calculates the variations V, which are representative of electric field variations (referred to a low electric field, whose measurement is obtained by means of a high gain) with respect to a zero height variation, detected by the altimeter 40.

Therefore, the high gain and the zero height variation allow the processing unit to identify the identification class CL related to a low voltage grounded power line, such as that of a home system and identifying a corresponding threshold value VS.

Advantageously, the method for operating the device 1 also allows correctly detecting the presence of the electric field generated by a power line also during the ascent of an operator along a framework. Indeed, along the framework, the electric field might be zero and, therefore, the processing unit 5 can detect, from the electric field sensor 3, field measurements E of zero intensity alternated with field measurements E of high intensity.

Nevertheless, the processing unit 5 itself detects position measurements S, in particular height measurements representative of the height variation of the operator measured by the altimeter 40, which are processed by the processing unit 5 which correlates the vicinity between the acquisition of the aforesaid field measurements E of zero intensity and of high intensity and of the height measurements, recognizing that the operator is approaching the wires of the power line by ascending along the framework.

Consequently, the processing unit 5 ignores the field measurements E with zero intensity so as to correctly signal the detected electric field and be able to communicate to the operator a possible danger condition through the warning signal A and the alarm signal AL emitted by the emitter 6.

Advantageously, the method for operating the device 1 is capable of signaling, to the operator, a danger condition even when the power line under maintenance has been correctly sectioned, in particular in the event in which such sectioned power line is placed in parallel with another power line that is not sectioned (e.g. for high and very high voltage aerial power lines).

In such situation, the electric current that flows into the non-sectioned power line is susceptible of inducing a voltage on the wires of the sectioned power line, in particular starting from the sectioning point. Therefore, the wires of the sectioned line might not be at zero potential, but rather they can have a voltage that can reach several hundred Volt.

In this case, while the operator approaches wires of the sectioned power line, by ascending height-wise, the processing unit 5 of the device 1 detects the presence of a weak electric field with respect to that expected if the power line had not been sectioned (which is advantageously detected by setting a high gain of the variable gain amplifier 51), but not due to a low voltage home electrical system, since the position sensor 4, and in particular the altimeter 40, detects the height variations by the operator with the increase of the measured electric field.

In this manner, the device 1 and its operating method allow an operator to safely operate even in the aforesaid situation.

Advantageously, the field measurements E detected by the processing unit 5 starting from the measurements of the electric field executed by the electric field sensor 3 contain frequency values of the electric field, and such frequency values allow the processing unit 5 itself to detect the operating frequency of the voltage on a specific power line.

In particular, the processing unit 5 is capable of detecting the fundamental operation frequency and the presence of possible harmonic components, at a multiple frequency of the fundamental component, as well as possible subharmonic components, at a frequency lower than the fundamental component.

Advantageously, the presence of specific voltage harmonics, such as for example the second harmonic (which in an operating system at 50 Hz has a value of 100 Hz), can indicate the presence of a photovoltaic plant connected to the power line, for example downstream of the sectioning point of the latter, which could be dangerous for the operator during the maintenance operations on the power line itself.

Therefore, the method for operating the device 1 allows the latter to detect the above-described danger condition, by means of the detection of the harmonic components present in the electric field measured by the electric field sensor 3, with the processing unit 5 that generates the warning signal A and the emitter 6 which emits the alarm signal AL.

The invention thus conceived therefore attains the pre-established objects.

## Claims

1. Electrical safety device (1), which comprises:
- a support element (2) arranged for being applied to an operator;
- an electric field sensor (3), which is mounted on said support element (2) and is arranged for measuring at least one electric field generated by at least one power line;
- at least one position sensor (4), which is mounted on said support element (2) and is arranged for detecting movements of said operator;
- at least one processing unit (5), which is operatively connected to said electric field sensor (3) in order to detect field measurements (E) containing at least intensity values of said electric field, is operatively connected to said position sensor (4) in order to detect position measurements (S) associated with corresponding said field measurements (E), and is adapted to calculate, at least from said field measurements (E) and from said position measurements (S), variations (V) of said electric field associated with said movements;
said processing unit (5) being arranged for generating a warning signal (A) as a function of said variations (V).

2. Electrical safety device (1) according to claim 1, **characterized in that** said electric field sensor (3) is an omnidirectional electric field sensor.

3. Electrical safety device (1) according to claim 2, **characterized in that** said electric field sensor (3) comprises a spherical capacitor (30).

4. Electrical safety device (1) according to any one of the preceding claims, **characterized in that** said at least one position sensor (4) comprises at least one altimeter (40).

5. Electrical safety device (1) according to any one of the preceding claims, **characterized in that** said at least one position sensor (4) comprises at least one accelerometer (41).

6. Electrical safety device (1) according to any one of the preceding claims, **characterized in that** it comprises an emitter (6), operatively connected to said processing unit (5) in order to receive said warning signal (A), and such warning signal (A) is adapted to actuate said emitter (6) to emit an alarm signal (AL).

7. Electrical safety device (1) according to any one of the preceding claims, **characterized in that** it comprises a data memory (50), which contains multiple identification classes (CL), each of which is associated with a corresponding power line and contains:
- reference parameters (P) representative of a spatial distribution of a reference electric field generated by the corresponding said power line;
- at least one threshold value (VS) of electric field intensity representative of a danger condition;
said processing unit (5) being arranged for:
- comparing said variations (V) with the reference parameters (P) of said identification classes (CL);
- selecting one said identification class (CL), in which said variations (V) fall within said reference parameters (P);
- comparing said field measurements (E) with said at least one threshold value (VS) of the selected said identification class (CL);
- generating said warning signal (A) as a function of said comparison.

8. Electrical safety device (1) according to any one of the preceding claims, wherein said electric field sensor (3) is arranged for generating electrical output signals (U) as a function of said detected electric field;
**characterized in that** it comprises a variable gain amplifier (51), which is electrically connected to said electric field sensor (3) in order to receive said output signals (U) and generate corresponding amplified measurement signals;
said processing unit (5) being operatively connected to said electric field sensor (3) through said variable gain amplifier (51) in order to calculate, based on said amplified measurement signals, said field measurements (E);
said processing unit (5) being arranged for setting different gains in said variable gain amplifier (51).

9. Electrical safety device (1) according to claim 8, **characterized in that** said processing unit (5) is provided with at least one search program in which:
- it sets a minimum gain as said gain in said variable gain amplifier (51);
- it acquires said amplified measurement signals;
- it processes said amplified measurement signals in order to calculate said field measurements (E);
so that said field measurements (E) do not contain significant values, iteratively, for a maximum number of cycles:
- it increases said gain by a specific increment;
- it acquires new said amplified measurement signals;
- it processes said new amplified measurement signals in order to calculate said field measurements (E).

10. Method for operating an electrical safety device (1) according to any one of the preceding claims, which comprises:
- a measurement step, in which said electric field sensor (3) measures at least one said electric field generated by at least one said power line;
- a step of detecting movements, in which said position sensor (4) detects movements of said operator;
- an acquisition step, in which said processing unit (5) detects:
- from said electric field sensor (3), said field measurements (E) containing at least the intensity values of said electric field;
- from said position sensor (4), said position measurements (S) associated with corresponding said field measurements (E);
- a processing step, in which said processing unit (5) calculates, at least from said field measurements (E) and from said position measurements (S), said variations (V) of said electric field associated with said movements;
- a signaling step, in which said processing unit (5) generates said warning signal (A) as a function of said variations (V).

11. Method according to claim 10 for operating an electrical safety device (1) according to claim 7, **characterized in that** it comprises:
- a first comparison step, in which said processing unit (5) compares said variations (V) with the reference parameters (P) of said identification classes (CL);
- a selection step, in which said processing unit (5) selects one said identification class (CL) in which said variations (V) fall within said reference parameters (P);
- a second comparison step, in which said processing unit (5) compares said field measurements (E) with said at least one threshold value (VS) of the selected said identification class (CL);
wherein, in said signaling step, said processing unit (5) generates said warning signal (A) when said field measurements (E) exceed said at least one threshold value (VS) of the selected said identification class (CL).

12. Method according to claim 10 or 11 for operating an electrical safety device (1) according to claim 9, **characterized in that** it comprises a setting step, in which:
- said variable gain amplifier (51) receives said output signals (U) generated by said electric field sensor (3) and generates the corresponding said amplified measurement signals;
- said processing unit (5):
- sets said minimum gain in said variable gain amplifier (51);
- acquires said amplified measurement signals;
- processes said amplified measurement signals in order to calculate said field measurements (E);
wherein, while said field measurements (E) do not contain significant values, said processing unit (5) executes iteratively, for said maximum number of cycles, the following operations:
- it increases said minimum gain by said specific increment;
- it acquires new said amplified measurement signals;
- it processes said new amplified measurement signals in order to calculate said field measurements (E).
